# EUROPEAN PATENT APPLICATION

(11) **EP 2 085 812 A2**
(43) Date of publication of application: **05.08.2009**
(21) Application number: 08172821.4
(22) Date of filing: 23.12.2008
(51) Int. Cl.: G02F 1/1333, G02F 1/153, H01J 17/49

(54) **Film Filter for a Flat Panel Display**

(30) Priority: 29.01.2008 KR 20080009045
(71) Applicant: Samsung SDI Co., Ltd., Gyeonggi-do (KR)
(72) Inventor: Kwon, Young-Kuk, Yeongtong-gu, Suwon-si, Gyeonggi-do (KR)
(74) Representative: Walaski, Jan Filip

(57) **Abstract**

A film filter and a flat panel display having the same capable of improving visibility and bright room contrast ratio. The film filter of the present embodiments comprises: first and second electrode layers disposed to be opposed to each other; a support layer having a hole and disposed between the first electrode layer and the second electrode layer; and a blind member disposed on the hole and of which transmittance is changed depending on electric field applied from the external.

## Description

The present invention relates to a film filter and a flat panel display having the same capable of increasing brightness and improving bright room contrast ratio.

A plasma display panel is a flat panel display using a gas discharge (plasma) phenomenon. Plasma display panels may be one of the next generation displays since they can simultaneously be large and thin compared to a CRT.

The plasma display panel is driven by discharge to emit electromagnetic interference, the electromagnetic waves affecting a human body or other electronic equipment. Therefore, the existing plasma display panel is requested to lower the emitted electromagnetic interference below a permissible level. To this end, most of the existing plasma display panels adopt a front filter capable of improving bright room contrast ratio by lowering reflectivity of external light simultaneously with blocking electromagnetic interference and near infrared rays.

The front filter is divided into a reinforced glass filter and a film filter according to use or non-use of glass. The reinforced glass filter is advantageous in that it is strong against external impact. However, the reinforced glass filter is disadvantageous in that it is heavy and expensive in installation since it has a thickness of about 3mm. Also, a problem arises in that an interface between the front filter and an upper glass of the panel is generated and an image is duplicatedly reflected due to refraction of light on the interface. Meanwhile, the film filter is advantageous in that it is light and thin and improves a duplicated image. However, the film filter has the same transmissivity of internal light as external light in view of light efficiency so that it has limitations in improving visibility and bright room/dark room contrast ratio of the display.

Also, the front filter has a light transmissivity of about 40 to 55% due to a colorant, etc. absorbing light of a specific wavelength in order to improve light properties, but such a light transmissivity lowers brightness of the display to cause a problem of bad visibility. Meanwhile, if the light transmissivity of the front filter is designed to be higher than 55%, the brightness is raised, but the bright room contrast ratio is reduced due to strong external light scattering. Accordingly, it is difficult to implement a high-quality moving picture. The present embodiments overcome the above problems as well as provide additional advantages.

It is an object of the present embodiments to provide a film filter capable of securing bright room contrast ratio even in the case where brightness of a flat panel display is raised.

It is another object of the present embodiments to provide a flat panel display including a film filter to have high brightness property and to secure desired bright room contrast ratio and visibility.

In order to achieve the objects, according to one aspect of the present invention, there is provided a film filter that is directly attached on a visible surface of a display, the film filter comprising: a support layer formed with a plurality of holes; first and second electrode layers disposed on both sides of the support layer; and a blind member inserted into the holes and of which transmittance is changed depending on an electric field applied through the first and second electrode layers.

The blind member may be formed of at least any one of suspended particles, photochromic devices, electrochromic devices, etc.

The film filter may further include an upper layer formed of an anti-reflective coating layer and/or an anti-glare layer. The film filter may further include an upper layer for any one of color correction, neon light block, and near infrared ray block. The film filter may further include an electromagnetic interference shielding layer as an upper layer. Herein, when the side where the flat panel display to which the film filter is to be attached is positioned is assumed as a lower on the basis of the film filter, the upper means an opposite side thereto.

The film filter may further include an adhesion layer. Also, the adhesion layer may include a colorant for any one of color correction, neon light blocking, and near infrared ray blocking.

The film filter may further include a transparent film. Herein, the transparent film may support the upper layer or the electromagnetic interference shielding layer.

The film filter may further include a power supply unit applying voltage between the first electrode layer and the second electrode layer.

According to another aspect of the present embodiments, there is provided a flat panel display comprising: a flat panel display body; and a film filter attached on a visible surface of the flat panel display body, wherein the film filter is the film filter according to one aspect of the present embodiments.

A support layer of the film filter has a black-based color, and has a pattern structure corresponding to a non-light-emitting region among a light-emitting region and the non-light-emitting region of the flat panel display.

These and/or other embodiments and features will become apparent and more readily appreciated from the following description of certain exemplary embodiments, taken in conjunction with the accompanying drawings in which:
FIG. 1 is a perspective view of a film filter according to one embodiment;
FIG. 2a and FIG. 2b are cross-sectional views explaining a structure and an operation process of a film filter of the present embodiments;
FIG. 3a and FIG. 3b are plan views of a structure of a support layer adoptable to the film filter of the present embodiments;
FIG. 4a to FIG. 4e are cross-sectional views showing a manufacturing process of the film filter of the present embodiments;
FIG. 5 is a cross-sectional view of a film filter according to another embodiment; and
FIG. 6 is a cross-sectional view of a flat panel display that comprises the film filter of the present embodiments.

Hereinafter, certain exemplary embodiments will be described with reference to the accompanying drawings. Further, elements that are not essential to the complete understanding of the embodiments are omitted for clarity. Also, like reference numerals refer to like elements throughout.

In the following description, the term "transparent" means being both substantially transparent as well as having transmissivity to the extent that it is commonly considered as transparent in this technical field.

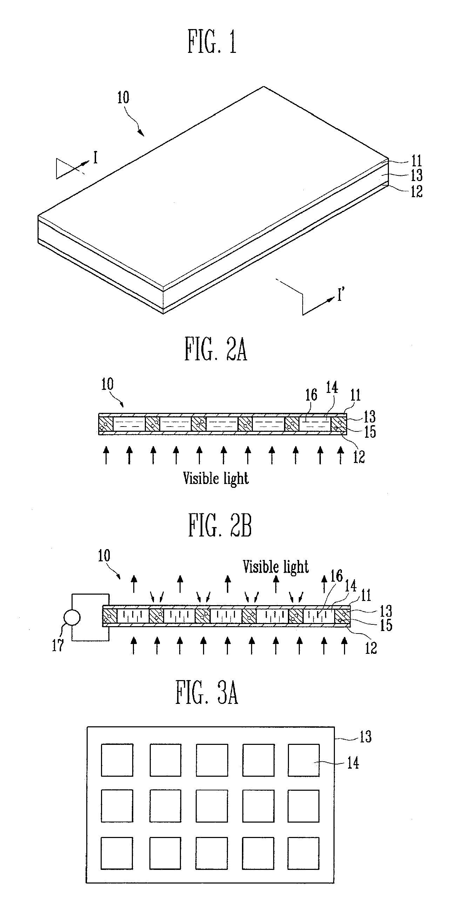

FIG. 1 is a perspective view of a film filter according to one embodiment.

Referring to FIG. 1, a film filter 10 comprises a first electrode layer 11 and a second electrode layer 12 disposed to be opposed to each other, and a support layer 13 disposed between the first electrode 11 and the second electrode layer 12. The film filter 10 may be attached on a visible surface of the flat panel display, using for example an adhesion layer.

In the embodiment, in order to raise brightness of the flat panel display to be attached and secure bright room contrast ratio and visibility thereof, the support layer 13 of the film filter 10 is patterned to have a light transmitting region and light non-transmitting region, wherein the light transmitting region includes a blind member, the transmittance of which can be changed depending on the applied electric field.

FIG. 2a and FIG. 2b are cross-sectional views explaining a structure and an operation process of a film filter of the present embodiments. FIG. 2a and FIG. 2b are cross-sections of the film filter taken along line I-I' of FIG. 1.

Referring to FIG. 2a, a support 13 is disposed between a first electrode layer 11 and a second electrode layer 12 of a film filter 10 and has a penetrating hole 14, also referred to as a through hole, or just hole. The support layer 13 may has a lattice shape by means of the penetrating hole 14. (See FIG. 3a) The support layer 13 may be made, for example, of at least one material selected from the group consisting of polyethersulphone (PES), polyacrylate (PAR), polyetherimide (PEI), polyethylene napthalate (PEN), polyethylene terephthalate (PET), polyphenylene sulfide (PPS), polyallylate, polyimide, polycabonate, triacetate cellulose (TAC), and cellulose acetate propionate (CAP).

Also, the support layer 13 includes a black-based colorant 15 in order to block the transmission of internal light and to absorb external light. The colorant may include material capable of representing the support layer 13 in, for example, black, e.g., a general pigment or dye capable of absorbing light of desired wavelength in a visible region, wherein the sort thereof is not specially limited. For example, the colorant can include organic colorants, such as an anthraquinone-based organic colorant, a phthalocyanine-based organic colorant, a methine-based organic colorant, an azomethine-based organic colorant, an oxadine-based organic colorant, an azo-based organic colorant, a styryl-based organic colorant, a coumarin-based organic colorant, a porphyrin-based organic colorant, a dibenzofuran -based organic colorant, a diketo-pyrrolo-pyrrole-based organic colorant, a rhodamine-based organic colorant, a xanthene-based organic colorant, and a pyrromethene-based organic colorant.

Types and density of colorants may be determined by absorption wavelengths and absorption coefficients of colorants, tones of the transparent layer, transmission property and transmissivity, etc. required for the filter film. According to some embodiments, the support layer 13 is formed of a black layer patterned in an approximate lattice shape.

The first electrode layer 11 and/or the second electrode layer 12 may be made of transparent material. The transparent material may include indium tin oxide (ITO), SnO2, etc. The first electrode layer 11 and/or the second electrode layer 12 may perform the function of shielding electromagnetic interference (EMI) emitted to a screen of a flat panel display.

Black, black-base or black-based color mean colors capable of blocking or absorbing most of the incident light as well as color commonly having a low transmissivity below a predetermined value in this technical field.

A blind member 16 is disposed on the penetrating hole 14 of the support layer 13. The transmittance of the blind member 16 is changed depending on the electric field applied through the first electrode layer 11 and the second electrode layer 12. For example, the blind member 16 becomes transparent to transmit light when the electric field is applied, and the blind member 16 becomes opaque to block light when the electric field is not applied. The blind member 16 may comprise, for example, suspended particles, photochromic devices, electrochromic devices, etc. The blind member is also referred to herein as a variable transmittance element.

For example, since liquid crystal molecules, that are suspended particles, of the blind member 16 which is manufactured by mixing liquid crystal molecules with polymers, exhibit random Brownian motion when the electric field is not applied, the incident light is absorbed or scattered to show a low transmittance. When the electric field is applied, the liquid crystal molecules are arranged in the electric field direction to be a transparent state, exhibiting high transmittance.

The blind member 16 using the suspended particles has additional advantages, beingcapable of blocking ultraviolet rays of about 99% or more and reflecting near infrared rays, in addition to advantages of being capable of easily controlling transmittance as a result of application of the electric field to the first electrode layer 11 and the second electrode layer 12.

The film filter 10 substantially does not transmit internal light to the outside through the support layer 13 and the blind member 16 in a standby mode, e.g.., in a mode where voltage is not applied to a first conductive layer 11 and a second conductive layer 12, as shown in FIG. 2a.

When voltage is applied to the first conductive layer 11 and the second conductive layer 12 from a power supply unit 17, as shown in FIG. 2b, the film filter 10 is converted to an active mode from the standby mode. At this time, the transmittance of the blind member 16 is changed to transmit the internal light to the outside. The external light may be absorbed by a black support layer 13. An alternating voltage (AC) of from about 30 to about 100V is required in the case of the blind member 16 using the suspended particles.

According to the present embodiment, in the pattern structure where a plurality of pixels of the flat panel display on which the film filter 10 is to be installed are arranged or in the case where the blind member 16 is arranged to face a light-emitting region and the support layer 13 is patterned to face the region other than the light-emitting region, e.g., a non-light-emitting region, the bright room/dark room contrast ration of the flat panel display can be improved through a light transmitting region of the blind member 16 corresponding to the pattern structure of the pixels and a light non-transmitting region of the support layer 13 corresponding to the non-light-emitting region when operating the flat panel display. Even in the case where brightness of the flat panel display is set to be high, desired bright room contrast ratio and visibility of the flat panel display can be easily secured through the light transmitting region of the blind member 16 and the light non-transmitting region of the support layer 13.

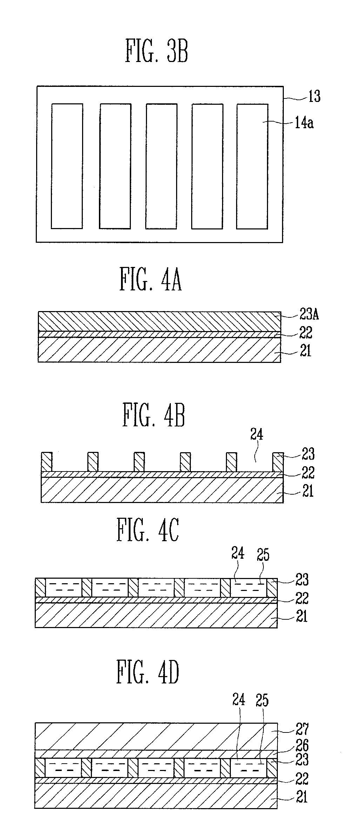

FIG. 3a and FIG. 3b are plan views of a structure of a support layer adoptable to a film filter of the present embodiments.

Referring to FIG. 3a, a support layer 13 may have a pattern structure in a lattice shape having a plurality of penetrating holes 14 separately arranged at predetermined intervals in view of a plan. In the present embodiment, although the shapes of the penetrating holes 14 are identically shown as a square or rectangle, each shape thereof may be identically or individually designed to be a polygon, a circle or a polygon including a circular arc, etc. by corresponding to each pixel region corresponding to each light-emitting region of the flat panel display on which the film filter is to be installed.

Also, as shown in FIG. 3b, the shape of the support layer 13 may be designed to have a stripe shape where the penetrating hole 14a is extended in one direction (up and down direction in FIG. 4), by corresponding to a pixel region of the flat panel display in one direction on which the film filter is to be installed.

FIG. 4a to FIG. 4e are cross-sectional views showing a manufacturing process of a film filter of the present embodiments.

First, polyethylene terephthalate (PET) pellets are melted at a temperature of from about 290°C to about 300°C and compressed using a compressor to manufacture a film with a thickness of about 200µm. The film is heated again and biaxially stretched to prepare a PET film 21 with a thickness of about 100µm.

A black PET film 23A including a colorant is prepared through a similar process with the preparation process of the PET film 21. For example, when manufacturing the PET film, it is melted and compressed by adding a predetermined content of black-based colorant with the PET pellets, making it possible to make a black PET film.

As shown in FIG. 4a, a conductive film 22 is formed on the transparent PET film 21. The conductive film 22 corresponds to the first electrode layer or the second electrode layer. Then, the black PET film 23A is attached on the conductive film 22. The attachment may be performed through a roll to roll process.

As shown in FIG. 4b, the black PET film 23A is patterned through a laser etching process to form a penetrating hole 24 so that a support layer 23 having a desired pattern structure is formed.

As shown in FIG. 4c, a blind member 25 is inserted into the penetrating hole 24 through, for example, a screen printing method, an inkjet printing method, a deposition method, etc.

Next, as shown in FIG. 4d, laminate formed with another conductive film 26 on another transparent PET film 27 is attached on the support layer 23 and the blind member 25 to manufacture a film filter.

In the aforementioned manufacturing process, in order to improve adhesion of the support layer 23 and the conductive films 22 and 26 and/or the transparent films 21 and 27 positioned on both sides thereof, the conductive films 22 and 26 may have a pattern structure including a main pattern corresponding to a penetrating hole 24 pattern (Refer to 14 of FIG. 3a) and a bus pattern (not shown) electrically coupling the main pattern and being exposed to the exterior. Herein, a pair of conductive films 22 and 26 may have a pattern structure where they are faced symmetrically putting the support layer 23 therebetween. Such a structure may be formed through a process such as a photolithography progress. In the aforementioned case, the layers 21, 23 and 27 made of the same PET material contact each other so that they can be easily attached to each other at high strength under a predetermined pressure and atmosphere.

Meanwhile, the conductive layers 22 and 26 of the present embodiment may be formed by being applied to almost entire surfaces of the transparent films 21 and 27, respectively. In this case, the present embodiments allow the support layer 23 to be directly contacted to the transparent films 21 and 27 by removing at least a portion of edges of the conductive films 22 and 26, making it possible to improve adhesion strength between the respective layers of the film filter.

The manufacturing method of the film filter of the present embodiment may use a method that inserts the blind member 25 into the penetrating hole 24 through a small gap coupling the external to the penetrating hole 24, in a state where the transparent films 21 and 27 attached with the conductive films 22 and 26 are stacked on both sides of the support layer 23 having the penetrating hole 24, and then blocks the gap. In this case, the blind member 25 is inserted into the penetrating hole 24, for example, by means of a capillary phenomenon or an atmospheric pressure difference.

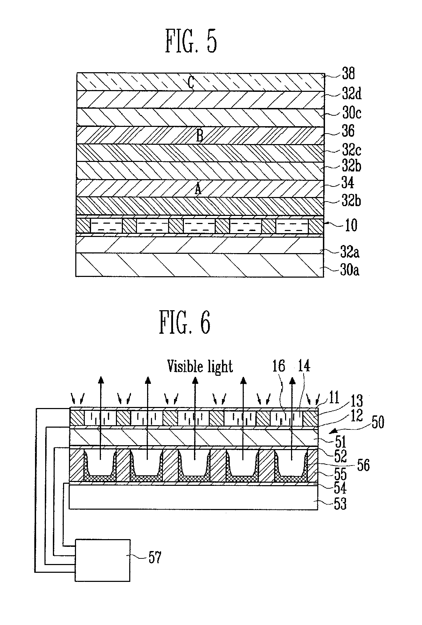

FIG. 5 is a cross-sectional view of a film filter according to another embodiment.

Referring to FIG. 5, a film filter of the present embodiments may additionally include at least one functional layer A, B, and C, in addition to a basic filter structure. Herein, the basic filter structure means the film filter 10 previously described with reference to FIG. 2a, and it will be referred to as a base layer 10 in the following description. The film filter includes a first transparent film 32a disposed on one surface (hereinafter, referred to as a lower surface) of the base layer 10. The first transparent film 32a corresponds to the transparent film 21 of FIG. 4d. A first adhesion layer 30a is disposed on the first transparent film 32a. The first adhesion layer 30a may be used when directly attaching the film filter to a visible surface of a flat panel display.

Also, the film filter includes a second transparent film 32b disposed on the other surface (hereinafter, referred to as an upper surface) of the base layer 10. The second transparent film 32b corresponds to the transparent film 27 of FIG. 4d.

An electromagnetic interference (EMI) shielding layer 34 that blocks electromagnetic interference is disposed on the second transparent film 32b. The electromagnetic interference (EMI) shielding layer 34 may be installed as a copper (Cu) thin film in a mesh shape or a conductive film having another predetermined pattern. A third transparent film 32c is disposed on the electromagnetic interference (EMI) shielding layer 34 by interposing a second adhesion layer 30b. The second adhesion layer 30b and the third transparent film 32c are installed in order to support an upper layer to be installed thereon, to improve adhesion strength between the upper layer and the electromagnetic (EMI) shielding layer 34 and to planarize the interface therebetween.

A color coating layer 36 for any color correction, such as, neon light block, and near infrared ray block, for example, is disposed on the third transparent film 32c. The color coating layer 36 includes a colorant such as a pigment or dye capable of selectively absorbing light of a specific wavelength in a visible light region. For example the colorant may comprise compounds capable of blocking unnecessary light with a wavelength of about 585nm emitted when neon is excited, such as, for example, a cyanine-based compound, an azomethine-based compound, a xanthene-based compound, an oxonol-based compound, an azo-based compound, etc. A fourth transparent film 32d is disposed on the color coating layer 36 by interposing a third adhesion layer 30c. The third adhesion layer 30c and the fourth transparent film 32d are installed to support an upper layer to be installed thereon, to improve adhesion strength between the upper layer and the color coating layer 36 and to planarize the interface therebetween.

In the case where the colorant of the color coating layer 36 is included in the first adhesion layer 30a and/or the second adhesion layer 30b, the color coating layer 36 and the third transparent film 32c and the third adhesion layer 30c disposed on the upper and lower surfaces of the color coating layer 36 may be omitted.

An anti-reflective coating layer 37 that prevents reflection and/or glare is formed on the fourth transparent film 32d. The anti-reflective coating layer 38 is disposed in order to minimize loss of the transmitted light and to prevent reflection and diffused reflection of external light. The anti-reflective coating layer 38 may be installed in a single layer structure or a multi-layer structure, wherein the single layer structure includes a thin film of fluorine-based transparent polymer resin, fluorinated magnesium, silicon-based resin, silicon oxide, etc., which has an optical film thickness of 1/4 wavelength, and the multi-layer structure includes inorganic compounds such as metal oxide, fluoride, silicide, carbide, nitride, and sulfide, which have different refraction indexes, and organic compounds such as silicon-based resin, acrylic resin, or fluoride-based resin, etc., in two or more layers. When forming the anti-reflective coating layer 38, a sputtering method, an ion plating method, an ion beam assist method, a vacuum deposition method, a chemical vapor deposition (CVD) method, a physical vapor deposition (PVD) method, etc. may be used.

Although not shown in FIG. 5, the film filter of the present embodiments may further include hard coating materials disposed on the anti-reflective coating layer 38. The hard coating materials may be installed for preventing scratch due to various forms of external force. It may be made using, for example, acrylic-based polymer, urethane-based polymer, epoxy-based polymer, siloxane-based polymer and it may be also made using ultraviolet rays reinforced resin such as an oligomer. In order to improve strength, silica-based filler may be additionally included. The aforementioned hard coating materials may be inserted into the anti-reflective coating layer 38, or may be disposed on the lower surface of the anti-reflective coating layer 38, e.g.., between the anti-reflective coating layer 38 and the fourth transparent film 32d, or may be disposed on the upper surface of the anti-reflective coating layer 38. The anti-reflective coating layer 38 including the hard coating material has a thickness T of from about 2 to about 7µm not to make its thickness too thick and to obtain the expected effects, wherein the anti-reflective coating layer 38 is exemplary designed to have the optical characteristics such as a low haze of from about 1 to about 3%, a visible transmittance of from about 30% to about 90%, a low external light reflectivity of from about 1 to about 20%, heat resistance of a glass transition temperature or more, and a pencil hardness of from about 2 to about 3H.

FIG. 6 is a cross-sectional view of a flat panel display that comprises a film filter of the present embodiments. In the present embodiment, a plasma display panel will be described as a flat panel display by way of example.

Referring to FIG. 6, a plasma display panel includes a panel body 50 and a film filter 10 attached to a visible surface of the panel body 50. Herein, the film filter 10 is the film filter explained above with reference to FIG. 2a. Of course, the film filter 10 may be replaced by another film filter explained above with reference to FIG. 5.

The panel body 50 includes a front plate and a back plate disposed to be opposed to each other. The front plate includes a first substrate 51, X-Y electrodes (not shown) disposed on the first substrate 51, a first dielectric layer 52 and a protecting layer (not shown), and the back plate includes a second substrate 53, an address electrode disposed on the second substrate 53, a second dielectric layer 54, a barrier rib 55, and a phosphor layer 56. Also, the panel body 50 includes a chassis base supporting a coupling structure of the front plate and the back plate and a driving circuit board disposed on one surface of the chassis base and configured of circuits driving the panel. The detailed structure and the operation principle of the panel body 50 will be omitted.

In the present embodiment, a penetrating hole 14 of a support layer 13 filled with a blind member 16 of a film filter 10 is disposed to face a discharge cell region of the panel body 50, that is, a discharge space where the phosphor 56 is applied, and a support layer 13 is disposed to face the barrier rib 55. According to the aforementioned structure, bright room contrast ratio of the panel body 50 can be improved through the film filter 10. Even in the case where brightness of the panel body 50 increases, bright room contrast ratio and visibility can be easily secured.

In the present embodiment, a power supply unit applying voltage to a first electrode layer 11 and a second electrode layer 12 of the film filter 10 may be included in a driving circuit or a power supply device mounted on the driving circuit board 57 within the panel body 50. In this case, the film filter can be operated depending on the operation or non-operation of the driving circuit, making it possible to easily control the film filter 10. A separate power supply unit for operating the film filter 10 may be omitted so that it is economic.

In the present embodiment, the plasma display panel is described as an illustrative example of a flat panel display. However, the present embodiments are not limited thereto. The present embodiments can be applied to display apparatuses such as a field emission display (FED), a vacuum fluorescent display (VFD), an organic light emitting display (OLED), a liquid crystal display (LCD), etc.

Even in the case where brightness of the flat panel display is designed to be high, the film filter of the present embodiments can remarkably improve bright room/dark room contrast ratio and visibility of the flat panel display by means of the black support layer acting on the light non-transmitting region and the blind member acting on the light transmitting region when an electric field is applied. Of course, the present embodiments can obtain the effect of the film filter compared with the reinforced glass filter, for example, the effect of removing a duplicated image due to the removal of interface with the flat panel display, and the effects making the flat panel display lightweight, thin and inexpensive.

Although exemplary embodiments have been shown and described, it would be appreciated by those skilled in the art that changes might be made in these embodiments without departing from the principles of the invention, the scope of which is defined in the claims.

## Claims

1. A film filter (10), comprising:
first and second electrode layers (11, 12);
a support layer (13) between the first and second electrode layers, the support layer having a plurality of holes (14); and
a variable transmittance element (16) in the holes;
wherein light transmittance through the film filter varies depending on an electric field applied to the variable transmittance element.

2. The film filter according to claim 1, wherein the first electrode layer and the second electrode layer comprise a transparent material.

3. The film filter according to claim 2, wherein the transparent material comprises indium tin oxide (ITO).

4. The film filter according to claim 1, wherein the variable transmittance element comprises at least one of suspended particles, photochromic devices, and electrochromic devices.

5. The film filter according to any one of the preceding claims, further comprising at least one of an upper layer of an anti-reflective coating layer, an anti-glare layer, and a combination thereof disposed on the first or second electrode layer.

6. The film filter according to claim 5, wherein the coating thickness of the upper layer is from about 2 to about 7µm;
wherein the pencil hardness of the upper layer is from about 2 to about 3H, and wherein haze of the upper layer is from about 1 to about 3%.

7. The film filter according to claim 5 or 6, further comprising:
an adhesion layer disposed on one surface of the upper layer; and
a color coating layer disposed on one surface of the adhesion layer or included in the adhesion layer configured to effect at least one of color correction, neon light blocking, and near infrared ray blocking.

8. The film filter according to any one of claims 1 to 6, further comprising an adhesion layer disposed on the first electrode layer or the second electrode layer.

9. The film filter according to claim 8, wherein the adhesion layer includes a colorant configured to effect at least one of color correction, neon light blocking and near infrared ray blocking.

10. The film filter according to claim 8, further comprising:
an electromagnetic interference shielding layer disposed on the first electrode layer or the second electrode layer.

11. The film filter according to any one of the preceding claims, further comprising a power supply unit for applying voltage to the first electrode layer and the second electrode layer.

12. The film filter according to any one of the preceding claims, further comprising at least one transparent film disposed on the first electrode layer or the second electrode layer.

13. The film filter according to any one of claims 1 to 4, further comprising:
an electromagnetic interference shielding layer disposed on the first electrode layer;
a color coating layer disposed on the electromagnetic interference shielding layer; and
an anti-reflective coating layer disposed on the color coating layer.

14. The film filter according to claim 13, further comprising:
a transparent film disposed between the first electrode layer and the electromagnetic interference shielding layer and another transparent film disposed on the second electrode layer.

15. A flat panel display comprising:
a flat panel display body; and
a film filter according to any one of the preceding claims attached on a visible surface of the flat panel display body.
